(19) Europäisches Patentamt
European Patent Office
Office européen des brevets

(11) **EP 3 026 033 A1**

(12) **EUROPEAN PATENT APPLICATION**
published in accordance with Art. 153(4) EPC

(43) Date of publication:
**01.06.2016 Bulletin 2016/22**

(21) Application number: **14828666.9**

(22) Date of filing: **24.07.2014**

(51) Int Cl.:
*C04B 35/00* (2006.01)    *H01L 41/187* (2006.01)
*H01L 41/43* (2013.01)

(86) International application number:
**PCT/JP2014/069538**

(87) International publication number:
**WO 2015/012344 (29.01.2015 Gazette 2015/04)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **25.07.2013 JP 2013154557**

(71) Applicant: **Hitachi Metals, Ltd.**
**Tokyo 108-8224 (JP)**

(72) Inventors:
• **KATO Tomotsugu**
  **Mishima-gun**
  **Osaka 618-0013 (JP)**
• **YAMADA Kouji**
  **Mishima-gun**
  **Osaka 618-0013 (JP)**

(74) Representative: **Fleuchaus, Michael A. et al**
**Fleuchaus & Gallo Partnerschaft mbB**
**Patent- und Rechtsanwälte**
**Steinerstrasse 15/A**
**81369 München (DE)**

(54) **CRYSTAL-ORIENTED PIEZOELECTRIC CERAMIC, PIEZOELECTRIC ELEMENT, AND METHOD FOR MANUFACTURING CRYSTAL-ORIENTED PIEZOELECTRIC CERAMIC**

(57)    A crystal-oriented piezoelectric ceramic including a major constituent represented by general formula $(1-s)A1B1O_3-sBaMO_3$ (where A1 is at least one element selected from alkali metals, B1 is at least one of transition metal elements and includes Nb, M is at least one of Group IVA elements and includes Zr, and $0.05 < s \leq 0.15$), the major constituent having a relative density of not less than 95.0% and not more than 98.5%.

FIG.10

EP 3 026 033 A1

**Description**

## TECHNICAL FIELD

The present invention relates to a crystal-oriented piezoelectric ceramic, a piezoelectric element, and a method for manufacturing a crystal-oriented piezoelectric ceramic.

## BACKGROUND ART

Conventionally, various ceramic materials have been developed as the piezoelectric material for use in piezoelectric devices. Among others, a piezoelectric ceramic which is made of $PbZrO_3$-$PbTiO_3$ (PZT) that is a lead-containing perovskite ferroelectric exhibits excellent piezoelectric characteristics. Therefore, PZT ceramics have been widely used in the fields of electronics, mechatronics, automobiles, etc.

However, in recent years, due to increasing awareness of environmental protection, the trend of avoiding use of metals such as Pb, Hg, Cd, and $Cr^{6+}$ in electronic and electric devices has been growing. In and around Europe, the directive on the restriction of the use (RoHS directive) took effect and was enforced.

Considering use of conventional lead-containing piezoelectric ceramics in a wide area, research on environment-friendly, lead-free piezoelectric ceramics is important and exigent. Therefore, lead-free piezoelectric ceramics which can exhibit performance comparable to conventional PZT piezoelectric ceramics have been occupying the interest of researchers.

Also, the piezoelectric ceramics are required to have a large piezoelectric constant d33 (mechanical displacement rate per electric field in the 33 direction).

As a polycrystalline ceramic which has a relatively high piezoelectric constant d33, a piezoelectric ceramic has been receiving attention in which the crystal is oriented (hereinafter, referred to as "crystal-oriented piezoelectric ceramic"), while the conventional piezoelectric ceramics are non-oriented piezoelectric ceramics.

For example, Patent Document 1 discloses a lead-free crystal-oriented piezoelectric ceramic. Specifically, Patent Document 1 discloses a crystal-oriented piezoelectric ceramic which is made of a polycrystal whose major phase is an isotropic perovskite type compound represented by general formula $ABO_3$, the isotropic perovskite type compound being a first perovskite type pentavalent metal oxide alkaline compound where the major constituents of the A site element are K and/or Na and the major constituents of the B site element are Nb, Sb and/or Ta, and in which specific crystal faces of respective crystal grains that constitute the polycrystal are oriented.

## CITATION LIST

### PATENT LITERATURE

Patent Document 1: Japanese Laid-Open Patent Publication No. 2003-12373

## SUMMARY OF INVENTION

### TECHNICAL PROBLEM

The conventional lead-free crystal-oriented piezoelectric ceramics have been required to have higher piezoelectric constants d33.

An object of the present invention is to provide a lead-free crystal-oriented piezoelectric ceramic which has a large piezoelectric constant d33, a piezoelectric element, and a method for manufacturing a piezoelectric ceramic.

### SOLUTION TO PROBLEM

A crystal-oriented piezoelectric ceramic of the present invention includes a major constituent represented by general formula $(1-s)A1B1O_3$-$sBaMO_3$ (where A1 is at least one element selected from alkali metals, B1 is at least one of transition metal elements and includes Nb, M is at least one of Group IVA elements and includes Zr, and $0.05 < s \leq 0.15$), the major constituent having a relative density of not less than 95.0% and not more than 98.5%.

In one embodiment, an orientation degree of the major constituent which is measured according to a Lotgering method is not less than 85%.

In one embodiment, a piezoelectric constant d33 of the major constituent is not less than 300 pm/V.

In one embodiment, in the general formula, $A1B1O_3$ is represented by $K_{1-x-y}Na_xLi_y(Nb_{1-z}Q_z)O_3$ (where Q is at least one of transition metal elements other than Nb, and x, y and z satisfy $0 < x < 1$, $0 < y < 1$ and $0 < z \leq 0.3$, respectively).

In one embodiment, M includes Zr in a proportion of 80% or more.

A piezoelectric element of the present invention includes: the crystal-oriented piezoelectric ceramic according to any of the above paragraphs; and a plurality of electrodes which are in contact with the crystal-oriented piezoelectric ceramic.

Another piezoelectric element of the present invention includes: a plurality of ceramic layers including the crystal-oriented piezoelectric ceramic according to any of the above paragraphs; and a plurality of internal electrodes, wherein the plurality of internal electrodes and the plurality of ceramic layers are alternately stacked up.

A method for manufacturing a crystal-oriented piezoelectric ceramic of the present invention includes the steps of: preparing first crystal powder which is made of a bismuth layered structure compound and which includes a $(Bi_2O_2)^{2+}$ layer and a pseudo-perovskite layer; decreasing Bi from the first crystal powder, thereby obtaining plate crystal powder which is made of a first perovskite type compound; mixing the plate crystal powder and an additive source material which is capable of producing a second perovskite type compound, thereby obtaining a mixture which has a composition generally represented by general formula $(1-s)A1B1O_3-sBaMO_3$ (where A1 is at least one element selected from alkali metals, B1 is at least one of transition metal elements and includes Nb, M is at least one of Group IVA elements and includes Zr, and $0.05 < s \leq 0.15$); casting the mixture, thereby obtaining an oriented compact; sintering the oriented compact in a reducing atmosphere at a temperature of not less than 1135°C and not more than 1170°C, thereby obtaining a sintered object whose relative density is not less than 95.0% and not more than 98.5%; and performing a heat treatment on the sintered object in an oxygen atmosphere.

## ADVANTAGEOUS EFFECTS OF INVENTION

According to the present invention, a crystal-oriented piezoelectric ceramic with a large piezoelectric constant d33, and a crystal-oriented piezoelectric ceramic with a high orientation degree, in which a ceramic having a composition represented by general formula $(1-s)A1B1O_3-sBaMO_3$ is used, can be provided. This enables to provide a lead-free piezoelectric element which has excellent responsiveness, i.e., which exhibits a large displacement even with a small voltage difference.

## BRIEF DESCRIPTION OF DRAWINGS

FIG. **1** is a flowchart illustrating an example of a method for manufacturing a crystal-oriented piezoelectric ceramic according to the present invention (up to production of plate crystal powder).

FIG. **2** is a flowchart illustrating an example of a method for manufacturing a crystal-oriented piezoelectric ceramic according to the present invention (after production of plate crystal powder).

FIG. **3** is a schematic diagram showing the structure of the first crystal powder.

FIG. **4** is a schematic cross-sectional view showing a sheet-like compact in which plate crystal powder is oriented.

FIG. **5** shows a SEM observation photograph of the first crystal powder.

FIG. **6** is a graph showing the result of X-ray diffraction of the first crystal powder.

FIG. **7** is a graph showing details of the composition of the first crystal powder.

FIG. **8** shows a SEM observation photograph of plate crystal powder.

FIG. **9** is a graph showing the relationship between the sintering temperature and the relative density and the relationship between the sintering temperature and the orientation degree in a crystal-oriented piezoelectric ceramic of the present invention.

FIG. **10** is a graph showing the relationship between the relative density and the orientation degree in the crystal-oriented piezoelectric ceramic of the present invention.

FIG. **11** is a graph showing the relationship between the sintering temperature and the relative density and the relationship between the sintering temperature and the orientation degree in a crystal-oriented piezoelectric ceramic of a comparative example.

FIG. **12** is a graph showing the relationship between the relative density and the orientation degree in the crystal-oriented piezoelectric ceramic of the comparative example.

## DESCRIPTION OF EMBODIMENTS

The piezoelectric constant d33 of the crystal-oriented piezoelectric ceramic exhibits a higher value as the orientation degree of the crystal increases. The orientation degree of the crystal depends on the orientation degree of plate crystal powder in a compact produced in the middle of manufacture.

Also, as the relative density (the density relative to the true density) of the crystal-oriented piezoelectric ceramic increases, the orientation degree of the crystal increases. Thus, it is supposed that a large piezoelectric constant d33 is obtained by increasing the relative density of the crystal-oriented piezoelectric ceramic.

The present inventors researched piezoelectric materials having a composition represented by general formula (1-s)A1B1O$_3$-sBaMO$_3$, which will be described later, for the purpose of realizing a piezoelectric ceramic with a large piezoelectric constant d33. As a result, the present inventors found that there is not always a correlation between the relative density and the orientation degree, and the piezoelectric constant d33 does not increase in some cases even if the relative density is increased. Hereinafter, embodiments of a crystal-oriented piezoelectric ceramic, a piezoelectric element, and a method for manufacturing a crystal-oriented piezoelectric ceramic according to the present invention are described in detail.

The crystal-oriented piezoelectric ceramic of the present invention has a composition represented by general formula (1-s)A1B1O$_3$-sBaMO$_3$. Here, A1 is at least one element selected from alkali metals, B1 is at least one of transition metal elements and includes Nb, M is at least one of Group IVA elements and includes Zr, and 0.05<s≤0.15.

The present inventors tried to further improve the piezoelectric constant d33 by means of crystal orientation in sintering of a compact that is produced using a ceramic which has the above-described composition. However, the present inventors found for the first time that, if the relative density exceeds 98.5%, the orientation degree decreases, which is contrary to the conventional common knowledge, and accordingly, the piezoelectric constant d33 also decreases.

In the specification of the present application, crystal orientation refers to a state where microcrystal grains in a polycrystal are oriented. For example, as will be described later, a crystal-oriented piezoelectric ceramic is obtained by sintering an oriented compact of the above-described composition in which plate-like powder for orientation (hereinafter, referred to as "plate crystal powder") is dispersed such that particles of the plate crystal powder are oriented in the same direction.

As will be described later in detail in the section of EXAMPLES, if a crystal-oriented piezoelectric ceramic which has the above-described composition has a relative density in the range of not less than 95.0% and not more than 98.5%, the orientation degree of the crystal is the highest and, accordingly, a high piezoelectric constant d33 is achieved.

[Composition of Crystal-Oriented Piezoelectric Ceramic]

Hereinafter, the composition of the crystal-oriented piezoelectric ceramic of the present invention is described.

A ceramic which constitutes the major constituent of the crystal-oriented piezoelectric ceramic of the present invention includes ceramic compositions represented by A1B1O$_3$ and BaMO$_3$.

In the present invention, the composition represented by A1B1O$_3$ is an alkali metal-containing niobium oxide. As described above, A1 is at least one element selected from alkali metals, and B1 is at least one of transition metal elements and includes Nb. The alkali metal-containing niobium oxide of this composition is known as a composition of a piezoelectric ceramic having a tetragonal perovskite structure with which a high piezoelectric constant can be readily achieved although it is free of lead, and also exhibits a high piezoelectric constant in the present embodiment.

Specifically, in the composition represented by A1B1O$_3$, A1 is at least one selected from alkali metals (K, Na, Li). Preferably, A1 includes K, Na and Li.

More specifically, A1B1O$_3$ is an alkali metal-containing niobium oxide based material and preferably has a composition represented by compositional formula K$_{1-x-y}$Na$_x$Li$_y$(Nb$_{1-z}$Q$_z$)O$_3$. Here, Q is at least one of transition metal elements other than Nb, and x, y and z satisfy 0<x<1, 0<y<1 and 0≤z≤0.3, respectively. Q is, for example, Ta, W or V.

When both K and Na are included as the alkali metals, high piezoelectric characteristics can be exhibited as compared with a case where K or Na is solely included. Li can provide the effect of increasing the Curie temperature and the effect of increasing the sinterability and hence improving the piezoelectric characteristics. Also, Li can provide the effect of improving the mechanical strength. Note that if the content y of Li exceeds 0.3, the piezoelectric characteristics are likely to decrease. Therefore, the content y of Li in the alkali metal is preferably 0<y≤0.3. The ranges of x, y and z are, more preferably, 0.3≤x≤0.7, 0.05≤y≤0.2 and 0≤z≤0.2, respectively.

BaMO$_3$ has the effect of increasing the dielectric constant. M preferably has a composition which includes Zr as the Group IVA element in a proportion of 80% or more. Other examples for M than Zr include Ti and Hf.

A1B1O$_3$ and BaMO$_3$ are contained in the piezoelectric ceramic in a ratio represented by general formula (1) shown below.

$$\text{(1-s)A1B1O}_3\text{-sBaMO}_3\text{(0.05<s≤0.15)} \;\dots\; \text{(1)}$$

When the content of BaMO$_3$ is in the range of 0.05<s≤0.15, a piezoelectric ceramic which has a high piezoelectric constant d33 and a high Curie temperature can be obtained. On the other hand, when s is not more than 0.05 or s exceeds 0.15, the resultant piezoelectric constant is excessively low so that it is difficult to obtain a practical piezoelectric ceramic. A preferred range of s is 0.065≤s≤0.11.

[Physical Properties of Crystal-Oriented Piezoelectric Ceramic]

As previously described, the crystal-oriented piezoelectric ceramic of the present invention has a relative density in the range of not less than 95.0% and not more than 98.5%. The orientation degree of the crystal-oriented piezoelectric ceramic which is measured according to the Lotgering method is not less than 85%. The piezoelectric constant d33 of the crystal-oriented piezoelectric ceramic is not less than 300 pm/V.

When a ceramic has a composition represented by general formula (1) and has a relative density in the range of not less than 95.0% and not more than 98.5%, the orientation degree of the ceramic can be not less than 85%. By carrying out a polarization treatment, a crystal-oriented piezoelectric ceramic which has a piezoelectric constant d33 of not less than 300 pm/V can be realized. General formula (1) does not include lead. Thus, a piezoelectric element can be realized which is formed of a crystal-oriented piezoelectric ceramic having a lead-free composition, and which exhibits a large displacement even with a small voltage difference, i.e., which has excellent responsiveness.

The crystal-oriented piezoelectric ceramic of the present invention is not limited to a piezoelectric ceramic which only includes the composition defined by general formula (1). If the content of a ceramic which has a composition represented by general formula (1) is not less than 80 mol%, it will exhibit a high piezoelectric constant d33. That is, it is only necessary that the composition represented by general formula (1) is included as a major constituent. In this case, it is only necessary that the relative density of the major constituent is not less than 95.0% and not more than 98.5%.

The crystal-oriented piezoelectric ceramic of the present invention may include a composition represented by $(R \cdot A2)TiO_3$ in addition to the above-described composition. In that case, the crystal-oriented piezoelectric ceramic is represented by general formula (1') shown below.

$$(1-s-t)A1B1O_3-sBaMO_3-t(R \cdot A2)TiO_3 \ldots (1')$$

Here, A1 is at least one element selected from alkali metals, B1 is at least one of transition metal elements and includes Nb, M is at least one of Group IVA elements and includes Zr, R is at least one of rare earth elements (including Y), A2 is at least one element selected from alkali metals, and $0.05 < s \leq 0.15$ and $0 \leq t \leq 0.03$.

$(R \cdot A2)TiO_3$ is a ceramic composition which has a rhombohedral perovskite structure. The composition represented by $(R \cdot A2)TiO_3$ is mixed with the composition represented by $A1B1O_3$, whereby a piezoelectric ceramic which has a tetragonal-rhombohedral phase boundary is obtained. This piezoelectric ceramic can have more excellent piezoelectric characteristics.

In the case of the above general formula, if t exceeds 0.03, the amount of expensive rare earth elements used increases, and accordingly, the source material cost also increases. From these viewpoints, a preferred range of t is $0.005 \leq t \leq 0.015$.

$(R \cdot A2)$ of the aforementioned formula $(R \cdot A2)TiO_3$ refers to $(R_{0.5}A2_{0.5})$. 0.5 includes the range of significant figures. That is, the ratio between R and A2 can be in the range of R:A2=0.45:0.54 to 0.54:0.45.

Particularly, it is preferred that R is at least one selected from Y, La and Ce. Among these elements, La is more preferred. Since the rare earth elements, such as La, Y and Ce, oxides of which have a low standard free energy of formation, are used, these elements undergo small volatilization during sintering, so that variation of the composition of the ceramic can be suppressed.

Particularly, it is preferred that A2 is at least one selected from the group consisting of Li, Na and K. Among these elements, Na is more preferred. Using these elements enables to increase the piezoelectric constant d33.

[Method For Manufacturing Crystal-Oriented Piezoelectric Ceramic]

Hereinafter, an embodiment of a method for manufacturing the crystal-oriented piezoelectric ceramic of the present invention is described.

The crystal-oriented piezoelectric ceramic of the present invention can be manufactured through, for example, the following five manufacturing steps:

(1) step of preparing the first crystal powder of a bismuth layered structure compound consisting of $(Bi_2O_2)^{2+}$ layers and pseudo-perovskite layers;

(2) step of decreasing Bi from the first crystal powder, thereby obtaining plate crystal powder which is made of the first perovskite type compound;

(3) step of mixing the plate crystal powder and an additive source material which is capable of producing the second perovskite type compound, thereby obtaining a mixture which has a composition generally represented by general formula $(1-s)A1B1O_3-sBaMO_3$ (where A1 is at least one element selected from alkali metals, B1 is at least one of transition metal elements and includes Nb, M is at least one of Group IVA elements and includes Zr, and $0.05<s\leq0.15$);

(4) step of casting the mixture, thereby obtaining an oriented compact;

(5) step of sintering the oriented compact in a reducing atmosphere at a temperature of not less than 1135°C and not more than 1170°C, thereby obtaining a sintered object whose relative density is not less than 95.0%;

(6) step of performing a heat treatment on the sintered object in an oxygen atmosphere; and

(7) step of performing a polarization treatment on the heat-treated sintered object.

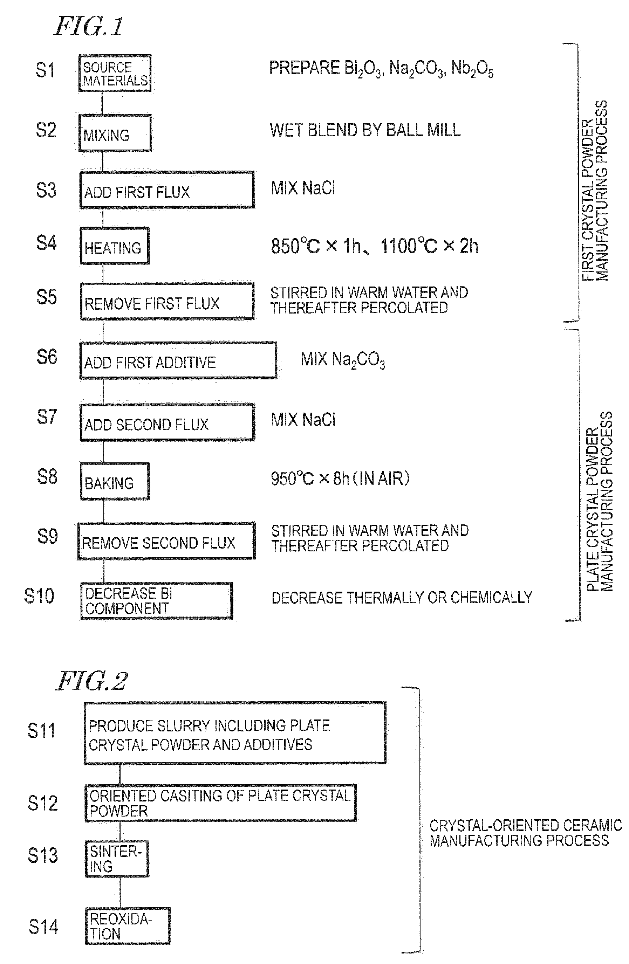

Hereinafter, the respective steps are described with reference to the flowcharts shown in FIG. **1** and FIG. **2.**

(1) Step of preparing the first crystal powder:

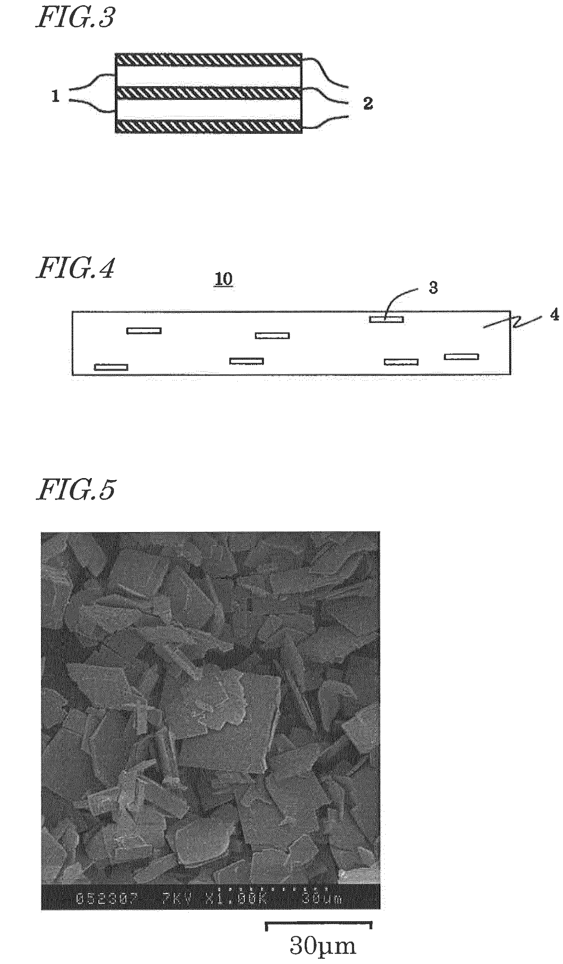

The first crystal powder which is made of a bismuth layered structure compound consisting of $(Bi_2O_2)^{2+}$ layers and pseudo-perovskite layers is prepared. This powder has a crystalline structure in which the $(Bi_2O_2)^{2+}$ layers **2** and the pseudo-perovskite layers **1** are alternately stacked up as shown in the schematic diagram of FIG. **3.**

As illustrated in step S1, the source materials are prepared. For example, in the present embodiment, the first crystal powder has a composition represented by general formula $(Bi_2O_2)^{2+} (Bi_{0.5}A3_{m-1.5}Nb_mO_{3m+1})^{2-}$ (where A3 is at least one element selected from alkali metals, and m is an integer not less than 2). In this general formula, the left side part represents the composition of the $(Bi_2O_2)^{2+}$ layers, and the right side part represents the composition of the pseudo-perovskite layers.

Another possible example of the first crystal powder in which the pseudo-perovskite layers do not include Bi is represented by general formula $(Bi_2O_2)^{2+}(A3_{m-1}B2_mO_{3m+1})^{2-}$ (where A3 is at least one element selected from alkali metals, B2 is at least one element selected from tetravalent, pentavalent and hexavalent elements, and m is an integer not less than 2). A3 is preferably at least one element selected from Li, K or Na. B2 is preferably at least one element of Nb and Ta.

As illustrated in step S2, source materials, such as $Bi_2O_3$, $Na_2CO_3$, $Nb_2O_5$, etc., are mixed together. Then, the source material mixture is dried. Thereafter, as illustrated in step S3, a flux of NaCl or the like is added to the dried mixture. As the flux, for example, a chloride of an alkali metal, such as NaCl and KCl, or a fluoride, nitrate or sulfate of an alkali metal may be used.

Thereafter, as illustrated in step S4, the source materials to which the flux has been added is heated in the air at a temperature of not less than 700°C and not more than 1300°C, whereby a reaction of the source materials is caused such that crystals which are to be the first crystal powder are grown. By this heating, a reaction product consisting of the first crystal powder and the flux can be obtained. In the heating, a multi-step heat treatment may be employed. To cause a sufficient reaction of the first crystal powder and the flux, the heating duration is preferably not less than 1 minute. Heating of long duration leads to a long treatment duration and to smaller aspect ratios in the shape of resultant plate powder. Therefore, the heating duration is preferably not more than 10 hours. A reaction product obtained after the baking (first intermediate baked object) is charged with the flux in its periphery and constitutes a generally-integral baked object.

As illustrated in step S5, to remove the flux from the reaction product, for example, the reaction product is immersed in warm water such that the reaction product melts. Thereby, only the first crystal powder can be extracted.

(2) Step of obtaining plate crystal powder:

The plate crystal powder is obtained by decreasing the Bi component from the first crystal powder. First, as illustrated in step S6, the first crystal powder and $Na_2CO_3$, which is the first additive, are mixed together. Further, as illustrated in step S7, NaCl, which is the second flux, is added and mixed. Thereby, a mixture consisting of the first crystal powder, the first additive and the second flux is obtained.

As illustrated in step S8, the mixture is heated, for example, in the air at a temperature of not less than 700°C and not more than 1200°C, whereby a reaction of the first crystal powder and the first additive is caused to obtain a reaction product. The heating duration is preferably not less than 1 hour and not more than 100 hours. Thereafter, as illustrated in step S9, the reaction product is immersed in warm water such that the second flux melts off.

As illustrated in step S10, the Bi component is decreased from the reaction product from which the flux has been removed. This can be realized thermally or chemically. For example, the reaction product from which the flux has been removed may be retained at a temperature not less than 500°C and not more than 1400°C in a reducing atmosphere such that Bi volatilizes. Alternatively, an acid may be used to dissolve Bi. Thereby, plate crystal powder with a high aspect ratio is obtained. The plate crystal powder has the composition of $NaNbO_3$.

(3) Step of obtaining a mixture which has a composition represented by general formula (1):

As illustrated in step S11, the plate crystal powder and an additive source material are mixed together. The additive source material is selected so as to realize a composition represented by general formula (1) when mixed with the plate crystal powder. The plate crystal powder is preferably added to the additive source material in a proportion of 0.1 to 10 mol%.

(4) Step of obtaining oriented compact:

As illustrated in step S12, after the plate crystal powder and the additive source material have been mixed together, the mixture is cast such that particles of the plate crystal powder are oriented inside the mixture. For example, the plate crystal powder, the additive source material, a binder, a plasticizer, and a solvent are mixed together into a slurry. The slurry is cast into the shape of a sheet. Thereby, a sheet-like oriented compact **10** is obtained in which particles of the plate crystal powder **3** are oriented in the additive source material **4** as shown in FIG. **4.**

It is preferred that the additive source material is in the form of powder, and the BET value of the additive source material is not less than 2.0 $m^2/g$ and not more than 3.0 $m^2/g$.

The orientation degree of the plate crystal powder dispersed in the sheet-like compact varies depending on the viscosity of the slurry and the thickness of the sheet to be cast.

The oriented compact may be a multilayer structure consisting of stacked sheet-like compacts or may be a structure in which an electrode of Ag or the like is provided between layers. In this way, the oriented compact is obtained.

(5) Step of obtaining a sintered object:

As illustrated in step S13, the oriented compact is sintered. Since particles of the plate crystal powder are oriented in the oriented compact, crystals of the additive source material and the compound of the plate crystal powder and the additive source material grow in the crystal orientation of the plate crystal powder. As a result, a ceramic of a high piezoelectric constant d33 which is entirely crystal-oriented can be obtained.

The sintering is preferably carried out in a reducing atmosphere at a temperature of not less than 1135°C and not more than 1170°C. As will be described later, carrying out the sintering within this temperature range facilitates obtaining a crystal-oriented ceramic whose relative density is not less than 95.0% and not more than 98.5%. The sintering temperature is more preferably not less than 1140°C and not more than 1160°C. Such a sintering temperature facilitates obtaining a crystal-oriented ceramic whose relative density is not less than 96.0% and not more than 98.0%. The reducing atmosphere is preferably an atmosphere in which, for example, the oxygen partial pressure is not more than $1 \times 10^{-4}$ kPa, more preferably not more than $1.6 \times 10^{-5}$ kPa. The details will be described later in the section of EXAMPLES.

(6) Step of performing a heat treatment on the sintered object in an oxygen atmosphere:

As illustrated in step S14, a heat treatment is performed on the resultant sintered object in an oxygen atmosphere. The oxygen partial pressure in the oxygen atmosphere preferably exceeds $10^{-4}$ kPa. Such an oxygen partial pressure can improve the piezoelectric constant d33 of the piezoelectric ceramic. Although the reasons for this are not clear, it is probably because, by performing the heat treatment in the atmosphere in which the oxygen partial pressure exceeds $10^{-4}$ kPa, the oxygen defects, such as $BaZrO_{3-m}$, are complemented with oxygen, so that a tetragonal-rhombohedral structural phase boundary clearly emerges. As a result, it is estimated that, the mole number of oxygen is optimized, and a ceramic of a perovskite structure is obtained in which the mole number of the A site:the mole number of the B site:the mole number of oxygen is closer to 1:1:3. That is, in this step, the oxygen defects are supplemented with oxygen, and a ceramic which has a composition represented by general formula (1) is obtained.

If the oxygen partial pressure is not more than $10^{-4}$ kPa, the resistance of the ceramic is low so that conduction readily occurs. Thus, it is difficult to obtain a ceramic which has piezoelectric characteristics.

In the case where the crystal-oriented piezoelectric ceramic of the present embodiment is realized as a multilayer piezoelectric element, it is preferred that the oxygen partial pressure is more than $10^{-4}$ kPa and not more than $10^{-2}$ kPa in order to suppress oxidation of the internal electrode included in the piezoelectric element. When a noble metal-based electrode such as an Ag-Pd alloy is used, performing the heat treatment in the air enables to obtain a piezoelectric ceramic in which the piezoelectric constant d33 and the Curie point Tc are further improved.

In the heat treatment, the pressure of the atmosphere is preferably the atmospheric pressure.

So long as the above-described oxygen partial pressure is achieved, the atmosphere used in reoxidation may contain any other inert gas, such as nitrogen or argon.

The temperature of the heat treatment is preferably not less than 500°C and not more than 1200°C. If the temperature is less than 500°C, oxygen defects are not sufficiently complemented with oxygen. Therefore, polarization cannot be achieved even when a polarization treatment is performed, and only a piezoelectric ceramic which has a small piezoelectric constant d33 can be obtained. On the other hand, if the heat treatment temperature is higher than 1200°C, there is a probability that the ceramic melts. A more preferred range of the heat treatment temperature is not less than 600°C and not more than 1100°C. The treatment duration is preferably not less than 0.5 hour and not more than 24 hours. If the treatment duration is shorter than 0.5 hour, the above-described complementation with oxygen is insufficient, so that there is a probability that a sufficiently high piezoelectric constant d33 is not achieved. If the treatment duration is longer than 24 hours, part of the elements which are constituents of the ceramic volatilize in some cases. A more preferred range of the treatment duration is not less than 1 hour and not more than 10 hours.

(7) Step of performing a polarization treatment on the heat-treated sintered object:

In the ceramic obtained in the above-described step, electrodes are formed, and a polarization treatment is performed. By the polarization treatment, uniform orientation of spontaneous polarization is achieved in the ceramic, and the ceramic expresses the piezoelectric characteristics. The polarization treatment may be a known polarization treatment which is commonly employed for manufacture of piezoelectric ceramics. For example, a baked object on which electrodes are formed is maintained at a temperature which is not less than the room temperature and not more than 200°C by using a silicone bath, and a voltage of about not less than 0.5 kV/mm and not more than 6 kV/mm is applied across the baked object. As a result, a crystal-oriented piezoelectric ceramic which has piezoelectric characteristics can be obtained.

The crystal-oriented piezoelectric ceramic of the present invention can be enabled in various forms. For example, the crystal-oriented piezoelectric ceramic may be used to form a sintered object in a bulk form. Alternatively, the present invention may be a piezoelectric element including the crystal-oriented piezoelectric ceramic of the present invention and a plurality of electrodes which are in contact with the crystal-oriented piezoelectric ceramic. In this case, it may be a multilayer piezoelectric element including a plurality of ceramic layers which are formed of the crystal-oriented piezoelectric ceramic of the present invention and a plurality of internal electrodes which are provided between the plurality of ceramic layers and which are made of Ag or the like.

Note that, in the case of a multilayer piezoelectric element, a different material of the internal electrodes or the like is present between the respective ceramic layers, and therefore, it is difficult to measure the relative density of the crystal-oriented piezoelectric ceramic. In this case, the relative density can be determined by measuring the porosity. The porosity $\varphi$ can be calculated from the formula of $\varphi = Sp/S$ where S is the cross-sectional area of the ceramic, and Sp is the area of voids which are present over that cross-sectional area. The value obtained by subtracting the value of this porosity $\varphi$ from 100 (%) is equal to the relative density. Therefore, it can be determined whether or not it is the crystal-oriented piezoelectric ceramic of the present invention according to whether or not the porosity $\varphi$ of the ceramic layers in the multilayer piezoelectric element is not more than 5%.

(EXAMPLES)

Various crystal-oriented piezoelectric ceramics were manufactured as an embodiment of the present invention. The results of evaluation of the characteristics of the manufactured piezoelectric ceramics are described.

First, the evaluation methods for the orientation degree and the piezoelectric constant d33 which were measured in the examples illustrated herein are described below.

[Composition]

The composition was measured by SEM-EDX (Energy Dispersive X-ray spectroscopy). The measurement conditions were as follows.
accelerating voltage: 15 kV
electric current: 100 nA
beam diameter: 1 $\mu$m

[True Density]

The mass of the unit cell of the perovskite structure was calculated from the prescribed composition. The volume of the unit cell was calculated from the measurement result of XRD (X-Ray Diffraction) of the sintered object. The value obtained by dividing the calculated mass of the unit cell by the calculated volume of the unit cell was adopted as the true density.

[Relative Density]

The relative density refers to the percentage (%) of the actually-measured density (measured by the Archimedes' method) relative to the true density that is assumed as 100%.

[Orientation Degree]

The orientation degree was determined according to the Lotgering method.

Specifically, the orientation degree was determined from the result of XRD using Cu-K$\alpha$ line. XRD was measured in the range of 2$\theta$:5° to 80° at a ground surface of the sintered object. P of the formula shown below was determined from the measurement result of XRD, and then, the orientation degree, f, was calculated. Here, P is the residual polarization value of the piezoelectric ceramic. $\Sigma$I{h00} is the total integrated intensity sum of a diffraction peak derived from {h00}. $\Sigma$I{hkl} represents the value of the total sum of the integrated intensities of all detected diffraction peaks. $P_0$ is the orientation degree of a non-oriented piezoelectric ceramic. A sintered object was produced without using the plate crystal powder, and the orientation degree of the sintered object was actually measured.

[Expression 1]

$$P = \frac{\sum I\{h00\}}{\sum I\{hkl\}}$$

[Expression 2]

$$f = \frac{P - P0}{1 - P0}$$

[Piezoelectric Constant d33]

After a polarization treatment was performed on respective samples, the piezoelectric constant d33 was measured. The polarization treatment was realized by forming Ag electrodes on the ceramic by sputtering and applying a DC electric field of 4.0 kV/mm at 413K (140°C) for 10 minutes.

The piezoelectric constant d33 was measured using a d33 meter (manufactured by the Institute of Acoustics, Chinese Academy of Sciences).

(Example 1)

First, the first crystal powder of a bismuth layered structure compound consisting of $(Bi_2O_2)^{2+}$ layers and pseudo-perovskite layers was prepared through the procedure shown in FIG. 1 (S1 to S5).

The source materials of $Bi_2O_3$, $Na_2CO_3$ and $Nb_2O_5$ were respectively weighed such that A3 is Na and m=5 in general formula $(Bi_2O_2)^{2+}$ $(Bi_{0.5}A3_{m-1.5}Nb_mO_{3m+1})^{2-}$, i.e., $Bi_{2.5}Na_{3.5}Nb_5O_{18}$, is obtained (step S1).

These source materials were mixed together by a ball mill. The solvent used was ethanol. The media used was zirconia balls. The mixing was carried out at 94 rpm for 24 hours. The media and source materials were pulled out from the container of the ball mill and dried in the air at 130°C. Thereafter, the source materials were separated by a sieve from the media (step S2).

NaCl was weighed in a proportion of 100 mass% relative to the separated source materials. The source materials and NaCl as the flux were dry blended together by a coarse grinder for 10 minutes (step S3).

The source materials, after addition of the flux, were subjected to two-step prebaking. Specifically, the source materials were retained in the air at 850°C for 1 hour and then retained at 1100°C for 2 hours. The increase and decrease of the temperature were about 200°C/h (step S4).

To decrease the flux component from the resultant prebaked object, the prebaked object was immersed in warm water at 95°C to 100°C and left there for 3 hours. Thereafter, the prebaked object was stirred in the warm water for 60 minutes, and a dewatering process was repeated three times. Thereby, the first crystal powder of general formula $Bi_{2.5}Na_{3.5}Nb_5O_{18}$ was obtained (step S5).

FIG. **5** is a SEM observation photograph of the first crystal powder. It can be seen that the crystals have plate-like shapes.

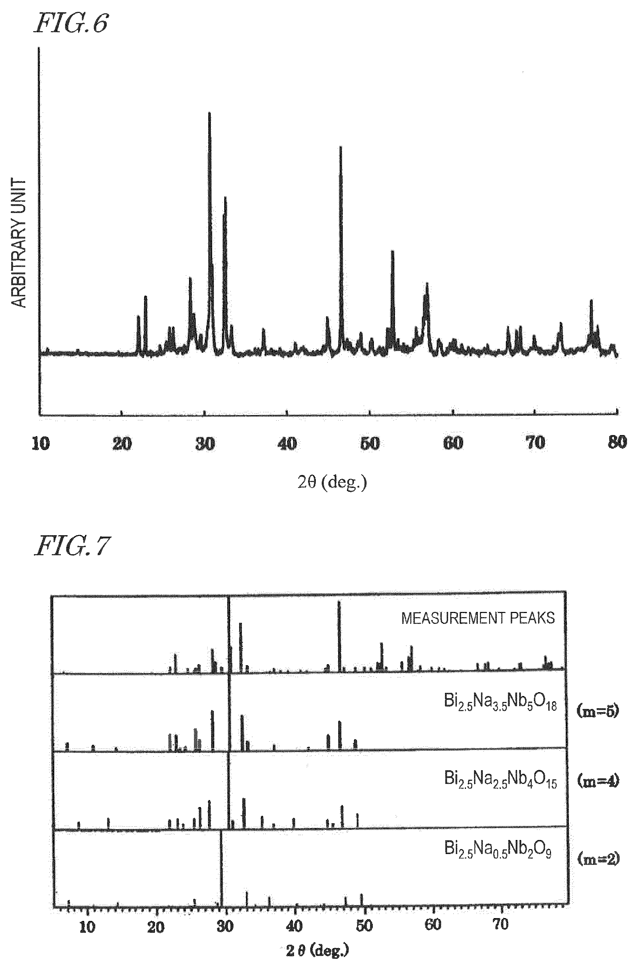

FIG. **6** shows the result of X-ray diffraction of the first crystal powder. FIG. **7** shows the result of identification of a compound with the use of that X-ray diffraction result. Note that all of the X-ray diffraction of the present invention were carried out using a K$\alpha$ line source of Cu.

Although almost all the crystals can be represented by general formula $Bi_{2.5}Na_{3.5}Nb_5O_{18}$, it can be seen that compounds other than that represented by general formula $Bi_{2.5}Na_{3.5}Nb_5O_{18}$, specifically a compound of $Bi_{2.5}Na_{0.5}Nb_2O_9$ which is obtained when m=2 in general formula $(Bi_2O_2)^{2+}$ $(Bi_{0.5}A3_{m-1.5}Nb_mO_{3m+1})^{2-}$ and a compound of $Bi_{2.5}Na_{2.5}Nb_4O_{15}$ which is obtained when m=4 in that general formula, are also included.

Then, the plate crystal powder of the first perovskite type compound obtained by decreasing Bi from the first crystal powder was prepared through the procedure shown in FIG. **1** (S6 to S10).

$Na_2CO_3$ was used as the first additive. $Na_2CO_3$ was weighed such that Na and Nb were in a ratio of 1:1 after a reaction with the first crystal powder and added to the first crystal powder. These were mixed together by a ball mill. The solvent used was ethanol. The media used was zirconia balls. The mixing was carried out at 94 rpm for 4 hours. The mixture was pulled out from the container of the ball mill and dried in the air at 130°C. Thereafter, the media was separated by a sieve (step S6).

NaCl was weighed in a proportion of 100 mass% relative to the first crystal powder. The mixture and NaCl as the flux were dry blended together by a coarse grinder for 10 minutes (step S7).

The mixture material consisting of the first crystal powder, the first additive and the flux was retained in the air at 950°C for 8 hours, whereby the second intermediate baked object was obtained. The increase and decrease of the temperature were about 200°C/h (step S8).

To decrease the flux component from the second intermediate baked object, the second intermediate baked object was immersed in warm water at 95°C to 100°C and left there for 3 hours. Thereafter, the second intermediate baked object was stirred in the warm water for 60 minutes, and a dewatering process was repeated three times (step S9).

Thereafter, decreasing of the Bi component is carried out by thermal or chemical means. In this example, the chemical means employed was pickling. The second intermediate baked object was pickled, whereby the Bi component was decreased from the second intermediate baked object. Specifically, an object to be treated, which was obtained at step S9, was immersed in a pickling solution consisting of pure water and a nitric acid in a proportion of about 3 to 10:1 and stirred. Thereafter, the solution was left till the Bi component remains in a supernatant solution, and the supernatant solution was discarded. Further, addition of the pickling solution, stirring, and discarding of the supernatant solution were repeatedly performed. Thereafter, residues were dried, whereby plate crystal powder of $NaNbO_3$ was obtained (step S10).

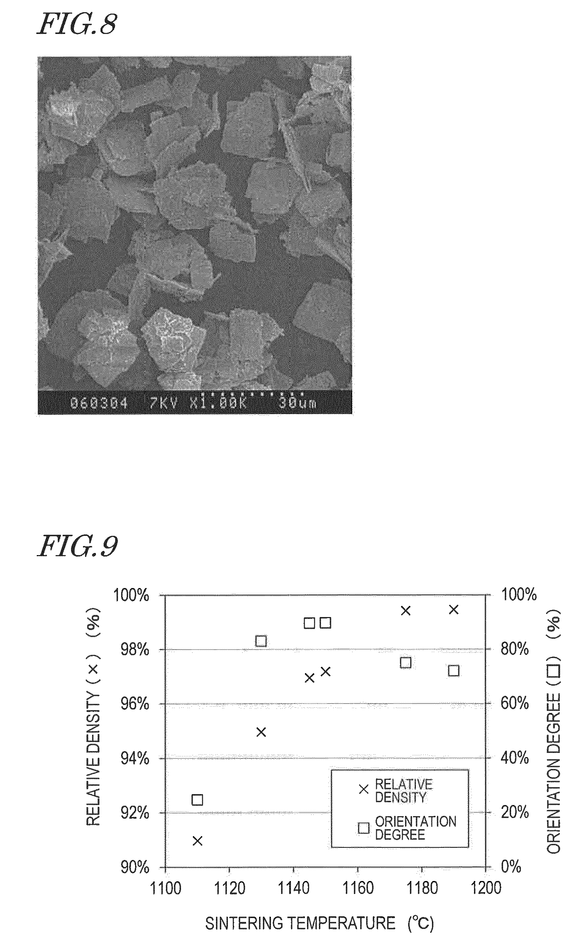

FIG. **8** is a SEM observation photograph of the plate crystal powder. The aspect ratio of this plate crystal powder (the ratio between the plate thickness and the maximum diameter) was about 10.

Then, a crystal-oriented piezoelectric ceramic was manufactured through the procedure shown in FIG. **2** (S11 to S14).

The plate crystal powder and the additive source material which is capable of producing the second perovskite type compound are mixed together, whereby a mixture was obtained which satisfies a composition generally represented by general formula $(1-s)A1B1O_3-sBaMO_3$ (where A1 is at least one element selected from alkali metals, B1 is at least one of transition metal elements and includes Nb, and $0.05 < s \leq 0.15$).

In this example, an additive source material including source materials of K, Na, Li, Ba, Nb and Zr was mixed into X mol plate crystal powder of $NaNbO_3$ such that a composition represented by $(K_{0.414}Na_{0.46-X}Li_{0.046}Ba_{0.08})$ $(Nb_{0.92-X}Zr_{0.08})O_3$ (s=0.08) was obtained. The additive source material used had a BET specific surface area of not less than 2.0 m$^2$/g and not more than 3.0 m$^2$/g.

The value of X mentioned above was 0.01 (step S11).

Then, this mixture was cast to obtain an oriented compact.

First, to convert the resultant mixture into a slurry form, ethanol and butanol were weighed so as to be 200 to 300 mass% and 50 to 100 mass%, respectively, relative to the mixture that is assumed as 100 mass%, and added to the mixture. Further, a plasticizer was added. In this example, dioctyl phthalate was used as the plasticizer and added in a proportion of 5 to 15 mass% relative to the mixture that is assumed as 100 mass%. Further, a binder was added. In this example, polyvinyl butyral was used as the binder and added in a proportion of 5 to 15 mass% relative to the mixture that is assumed as 100 mass%. The thus-obtained slurry was cast into the shape of a sheet (step S12).

Then, the oriented compact, which was cast into the shape of a sheet, was sintered in a reducing atmosphere at a temperature of 1110°C to 1190°C.

In carrying out this example, the sintering temperatures were 1110°C (Comparative Example 1), 1130°C (Comparative Example 2), 1145°C (Example 1), 1150°C (Example 2), 1175°C (Comparative Example 3), and 1190°C (Comparative Example 4). In each of the examples, the retention time was 4 hours. The reducing atmosphere was a nitrogen atmosphere in which the content of hydrogen was 2% (step S13).

Thereafter, a heat treatment was performed at 1000°C for 4 hours in an oxidizing atmosphere whose oxygen partial pressure was $2.1 \times 10^1$ kPa (step S14).

The true density, relative density, orientation degree, piezoelectric constant d33 and porosity of the resultant crystal-oriented piezoelectric ceramic were measured. The results are shown in Table 1. The relationship between the sintering temperature and the relative density and the relationship between the sintering temperature and the orientation degree are shown in FIG. **9.**

The crystal-oriented piezoelectric ceramic of this example, which was sintered at a temperature of not less than 1135°C and not more than 1170°C, has a relative density of not less than 95.0% and not more than 98.5%.

[Table 1]

|  | Sintering Temperature (°C) | True Density (g/cm$^3$) | Relative Density(%) | Orientation Degree(%) | Piezoelectric Constant d33 (pm/V) | Porosity (%) |
|---|---|---|---|---|---|---|
| Comparative Example 1 | 1110 | 4.26 | 91.0 | 24. 7 | Shot Circuit | 9.0 |
| Comparative Example 2 | 1130 | 4.45 | 94.9 | 83.1 | Shot Circuit | 5.1 |
| Example 1 | 1145 | 4.54 | 96.9 | 89.5 | 380 | 3.1 |
| Example 2 | 1150 | 4.55 | 97.2 | 89. 7 | 415 | 2.8 |
| Comparative Example 3 | 1175 | 4.66 | 99.4 | 75.1 | 290 | 0.6 |
| Comparative Example 4 | 1190 | 4.66 | 99.5 | 72.1 | Short Circuit | 0.5 |

As seen from FIG. **9,** the crystal-oriented piezoelectric ceramic represented by compositional formula (1) shows a tendency to have a higher relative density as the sintering temperature increases within the range of 1110°C to 1190°C. However, samples sintered near 1150°C show high orientation degree values. That is, the relationship between the relative density and the orientation degree is not linear. The orientation degree reaches the maximum within the range of not less than 1135°C and not more than 1170°C.

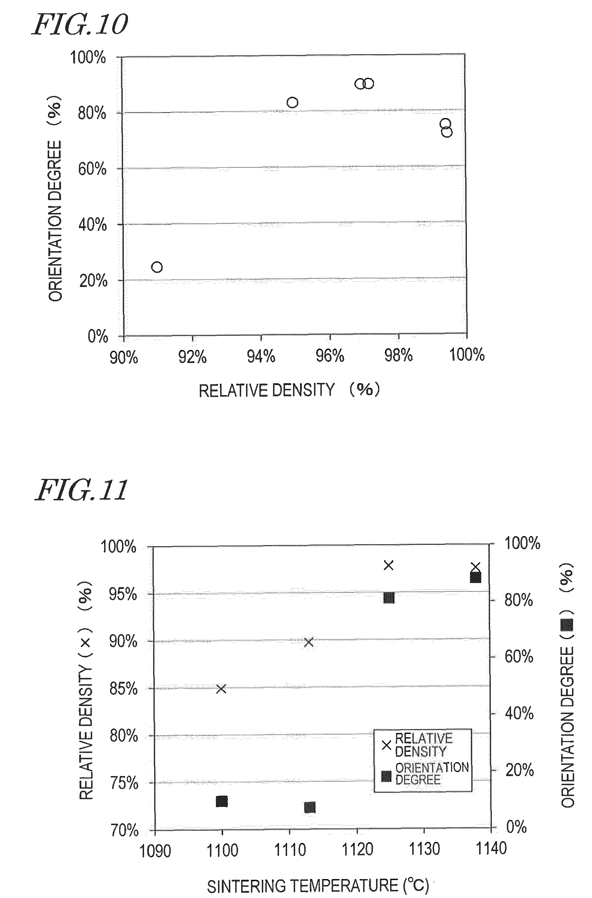

FIG. **10** shows the relationship between the relative density and the orientation degree. It can be seen that the orientation degree reaches the maximum (89% or more) within the relative density range of not less than 95.0% and not more than 98.5%.

A crystal-oriented piezoelectric ceramic which was obtained at a sintering temperature of less than 1135°C or more than 1170°C exhibited a relative density of less than 95.0% or more than 98.5%. The orientation degree was less than 85%. Measurement of the piezoelectric constant d33 was impossible because electrical conduction between the electrodes (short circuit) occurred in the polarization treatment so that the piezoelectric characteristics were not expressed.

Meanwhile, in a crystal-oriented piezoelectric ceramic which was obtained at a sintering temperature of not less than 1135°C and not more than 1170°C, the relative density was not less than 95.0% and not more than 98.5%, and the orientation degree was not less than 85%. The piezoelectric constant d33 exhibited a large value of not less than 300 pm/V.

The value of (100-porosity ($\varphi$) (%) was equal to the value of the relative density.

(Comparative Example 5)

A crystal-oriented piezoelectric ceramic having a composition of $A1B1O_3(NaNbO_3)$, which did not include $BaMO_3$ in the ceramic composition, was manufactured.

Plate crystal powder ($NaNbO_3$) was obtained in the same way as Examples 1 and 2.

A Na source material and a Nb source material were added to this plate crystal powder so as to constitute 96 mol $NaNbO_3$ relative to 4 mol plate crystal powder, whereby a mixture having a composition represented by $NaNbO_3$ was obtained.

This mixture was used to manufacture a crystal-oriented piezoelectric ceramic through the procedure shown in FIG. **2** (S11 to S14) in the same way as Examples 1 and 2.

The true density, relative density, orientation degree, and piezoelectric constant d33 of the resultant crystal-oriented piezoelectric ceramic were measured in the same way as Examples 1 and 2.

The relationship between the sintering temperature and the relative density and the relationship between the sintering temperature and the orientation degree are shown in FIG. **11**. The crystal-oriented piezoelectric ceramic of Comparative Example 5 having a composition of $NaNbO_3$ shows a tendency to have a higher relative density as the baking temperature increases within the sintering temperature range of 1100°C to 1140°C. The relationship between the baking temperature and the orientation degree also shows the same tendency.

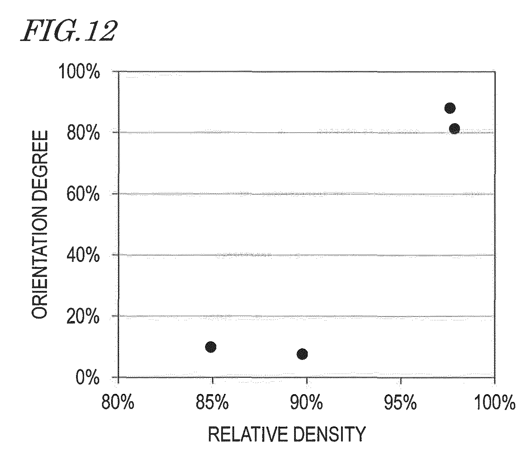

FIG. **12** shows the relationship between the relative density and the orientation degree in the crystal-oriented piezoelectric ceramic of Comparative Example 5. When the relative density was not less than 95.0%, the orientation degree was large, specifically not less than 80%. It can be seen that, as conventionally known, it shows a tendency to have a higher orientation degree as the relative density increases. This tendency is different from that of the crystal-oriented piezoelectric ceramic of the present invention.

(Example 3)

An oriented compact in the shape of a sheet was produced in the same way as Example 1.

A plurality of sheets of this oriented compact in the shape of a sheet were prepared. Each of the sheets was pattern printed with an Ag electrode paste.

10 sheets of the oriented compact which were printed with the electrode paste were stacked up and compressed together by warm CIP at 85°C and 11.6 MPa, whereby a multilayer oriented compact was obtained.

This multilayer oriented compact was sintered at a sintering temperature of not less than 1135°C and not more than 1170°C. The retention time was 4 hours. Thereafter, a heat treatment was performed at 1000°C for 4 hours in an oxidizing atmosphere whose oxygen partial pressure was $2.1 \times 10^1$ kPa.

The porosity, orientation degree, and piezoelectric constant d33 of the resultant multilayer piezoelectric element were measured.

The porosity (%) was not more than 5.0% (the relative density was not less than 95.0%). The orientation degree was not less than 85%. The piezoelectric constant d33 exhibited a large value not less than 3000 pm/V (d33 of the crystal-oriented piezoelectric ceramic per one sheet (300 pm/V)$\times$the number of stacked sheets (10)).

(Examples 4 and 5)

Crystal-oriented piezoelectric ceramics were manufactured with different values for s in the general formula of Examples 1 and 2.

Plate crystal powder of $NaNbO_3$ was obtained in the same way as Example 1 (steps S1 to 10).

Thereafter, in Examples 4 and 5, an additive source material including source materials of K, Na, Li, Ba, Nb and Zr was mixed into X mol plate crystal powder of $NaNbO_3$ such that compositions represented by $(K_{0.414}Na_{0.46-X}Li_{0.046}Ba_S)(Nb_{1-X-S}Zr_S)O_3$ (s=0.07, 0.10) (Examples 4, 5) were obtained. The value of X mentioned above was 0.01 (step S11).

Then, this mixture was cast in the same way as Example 1 to obtain an oriented compact (step S12).

Then, the oriented compact, which was cast into the shape of a sheet, was sintered in a reducing atmosphere at 1150°C. In each of the examples, the retention time was 4 hours. The reducing atmosphere was a nitrogen atmosphere in which the content of hydrogen was 2% (oxygen partial pressure: $1.6 \times 10^{-8}$ kPa).

Thereafter, a reoxidation treatment was performed at 1000°C for 4 hours in an oxidizing atmosphere whose oxygen partial pressure was $2.1 \times 10^1$ kPa.

The true density, relative density, orientation degree, piezoelectric constant d33, and porosity of the resultant crystal-oriented piezoelectric ceramic were measured. The results are shown in Table 2.

Even when the value of s in the general formula is 0.07 or 0.10, a crystal-oriented piezoelectric ceramic was obtained whose piezoelectric constant d33 was not less than 300 pC/N.

[Table 2]

| | s | Sintering Temperature (°C) | True Density (g/cm$^3$) | Relative Density(%) | Orientation Degree(%) | Piezoelectric Constant d33 (pm/V) | Porosity (%) |
|---|---|---|---|---|---|---|---|
| Example 4 | 0.07 | 1150 | 4.52 | 96.6 | 87.5 | 340 | 3.4 |
| Example 5 | 0.10 | 1150 | 4.58 | 97.9 | 88.0 | 310 | 2.1 |

It was found from the above results that a crystal-oriented piezoelectric ceramic which has a composition represented by general formula (1) and whose relative density is not less than 95.0% and not more than 98.5% can have an orientation degree of not less than 85%. It was also found that this crystal-oriented piezoelectric ceramic has a piezoelectric constant d33 of not less than 300 pm/V.

It was found that, in the crystal-oriented piezoelectric ceramic having a composition represented by general formula (1), the relative density and the orientation degree are not in a proportional relationship when the relative density is in a region of not less than 95%, and the orientation degree is the highest when the relative density is in the range of not less than 95.0% and not more than 98.5%. Thus, it was found that a larger piezoelectric constant d33 is exhibited when the relative density is not less than 95.0% and not more than 98.5%.

On the other hand, in a ceramic having a composition of Comparative Example 5 ($NaNbO_3$), for example, it was found that, as the relative density becomes closer to 100% in a region of not less than 95%, the orientation degree increases, and the piezoelectric constant d33 also increases.

## REFERENCE SIGNS LIST

**1** pseudo-perovskite layer
**2** $(Bi_2O_2)^{2+}$ layer
**3** plate crystal powder
**4** additive source material
**10** oriented compact

## Claims

1. A crystal-oriented piezoelectric ceramic comprising a major constituent represented by general formula (1-s)$A1B1O_3$-$sBaMO_3$ (where A1 is at least one element selected from alkali metals, B1 is at least one of transition metal elements and includes Nb, M is at least one of Group IVA elements and includes Zr, and $0.05<s\leq0.15$), the major constituent having a relative density of not less than 95.0% and not more than 98.5%.

2. The crystal-oriented piezoelectric ceramic of claim 1, wherein an orientation degree of the major constituent which is measured according to a Lotgering method is not less than 85%.

3. The crystal-oriented piezoelectric ceramic of claim 1 or 2, wherein a piezoelectric constant d33 of the major constituent is not less than 300 pm/V.

4. The crystal-oriented piezoelectric ceramic of any of claims 1 to 3, wherein in the general formula, $A1B1O_3$ is represented by $K_{1-x-y}Na_xLi_y(Nb_{1-z}Q_z)O_3$ (where Q is at least one of transition metal elements other than Nb, and x, y and z satisfy $0<x<1$, $0<y<1$ and $0\leq z\leq0.3$, respectively).

5. The crystal-oriented piezoelectric ceramic of any of claims 1 to 4, wherein M includes Zr in a proportion of 80% or more.

6. A piezoelectric element, comprising:

   the crystal-oriented piezoelectric ceramic according to any of claims 1 to 5; and
   a plurality of electrodes which are in contact with the crystal-oriented piezoelectric ceramic.

7. A piezoelectric element, comprising:

   a plurality of ceramic layers including the crystal-oriented piezoelectric ceramic according to any of claims 1 to 5; and
   a plurality of internal electrodes,
   wherein the plurality of internal electrodes and the plurality of ceramic layers are alternately stacked up.

8. A method for manufacturing a crystal-oriented piezoelectric ceramic, comprising the steps of:

   preparing first crystal powder which is made of a bismuth layered structure compound and which includes a

$(Bi_2O_2)^{2+}$ layer and a pseudo-perovskite layer;

decreasing Bi from the first crystal powder, thereby obtaining plate crystal powder which is made of a first perovskite type compound;

mixing the plate crystal powder and an additive source material which is capable of producing a second perovskite type compound, thereby obtaining a mixture which has a composition generally represented by general formula $(1-s)A1B1O_3$-$sBaMO_3$ (where A1 is at least one element selected from alkali metals, B1 is at least one of transition metal elements and includes Nb, M is at least one of Group IVA elements and includes Zr, and $0.05 < s \leq 0.15$);

casting the mixture, thereby obtaining an oriented compact;

sintering the oriented compact in a reducing atmosphere at a temperature of not less than 1135°C and not more than 1170°C, thereby obtaining a sintered object whose relative density is not less than 95.0% and not more than 98.5%; and

performing a heat treatment on the sintered object in an oxygen atmosphere.

## FIG.1

| | | |
|---|---|---|
| S1 | SOURCE MATERIALS | PREPARE $Bi_2O_3$, $Na_2CO_3$, $Nb_2O_5$ |
| S2 | MIXING | WET BLEND BY BALL MILL |
| S3 | ADD FIRST FLUX | MIX NaCl |
| S4 | HEATING | $850°C \times 1h$、 $1100°C \times 2h$ |
| S5 | REMOVE FIRST FLUX | STIRRED IN WARM WATER AND THEREAFTER PERCOLATED |
| S6 | ADD FIRST ADDITIVE | MIX $Na_2CO_3$ |
| S7 | ADD SECOND FLUX | MIX NaCl |
| S8 | BAKING | $950°C \times 8h$ (IN AIR) |
| S9 | REMOVE SECOND FLUX | STIRRED IN WARM WATER AND THEREAFTER PERCOLATED |
| S10 | DECREASE Bi COMPONENT | DECREASE THERMALLY OR CHEMICALLY |

FIRST CRYSTAL POWDER MANUFACTURING PROCESS (S1–S5)

PLATE CRYSTAL POWDER MANUFACTURING PROCESS (S6–S10)

## FIG.2

| | |
|---|---|
| S11 | PRODUCE SLURRY INCLUDING PLATE CRYSTAL POWDER AND ADDITIVES |
| S12 | ORIENTED CASITING OF PLATE CRYSTAL POWDER |
| S13 | SINTER-ING |
| S14 | REOXIDA-TION |

CRYSTAL-ORIENTED CERAMIC MANUFACTURING PROCESS

*FIG.3*

*FIG.4*

*FIG.5*

30μm

*FIG.6*

*FIG.7*

*FIG.8*

*FIG.9*

*FIG.10*

*FIG.11*

FIG.12

## INTERNATIONAL SEARCH REPORT

| | International application No. |
|---|---|
| | PCT/JP2014/069538 |

A. CLASSIFICATION OF SUBJECT MATTER
*C04B35/00*(2006.01)i, *H01L41/187*(2006.01)i, *H01L41/43*(2013.01)i

According to International Patent Classification (IPC) or to both national classification and IPC

B. FIELDS SEARCHED

Minimum documentation searched (classification system followed by classification symbols)
C04B35/00, H01L41/187, H01L41/43

Documentation searched other than minimum documentation to the extent that such documents are included in the fields searched

| | | | |
|---|---|---|---|
| Jitsuyo Shinan Koho | 1922–1996 | Jitsuyo Shinan Toroku Koho | 1996–2014 |
| Kokai Jitsuyo Shinan Koho | 1971–2014 | Toroku Jitsuyo Shinan Koho | 1994–2014 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y<br>A | WO 2005/021461 A1 (National Institute of Advanced Industrial Science and Technology), 10 March 2005 (10.03.2005), claims 1, 3, 4; paragraphs [0010], [0014], [0026], [0032], [0035]<br>& JP 4491537 B2 | 1,4–7<br>2,3,8 |
| Y | JP 2012-246178 A (Canon Inc.), 13 December 2012 (13.12.2012), paragraphs [0001] to [0007], [0066] to [0088]<br>& US 2014/0106170 A1 & EP 2714593 A<br>& WO 2012/165267 A1 & CN 103732539 A<br>& KR 10-2014-0025521 A | 1,4–7 |

☒ Further documents are listed in the continuation of Box C. ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| 22 October, 2014 (22.10.14) | 04 November, 2014 (04.11.14) |

| Name and mailing address of the ISA/<br>Japanese Patent Office | Authorized officer |
|---|---|
| Facsimile No. | Telephone No. |

Form PCT/ISA/210 (second sheet) (July 2009)

**INTERNATIONAL SEARCH REPORT**

International application No.

PCT/JP2014/069538

C (Continuation).    DOCUMENTS CONSIDERED TO BE RELEVANT

| Category* | Citation of document, with indication, where appropriate, of the relevant passages | Relevant to claim No. |
|---|---|---|
| A | JP 2010-222185 A  (Denso Corp.),<br>07 October 2010 (07.10.2010),<br>claim 1; paragraphs [0017], [0101] to [0135]<br>(Family: none) | 1-8 |
| A | JP 2007-269603 A  (Fujifilm Corp.),<br>18 October 2007 (18.10.2007),<br>paragraphs [0022], [0040] to [0054]<br>& US 2007/0228318 A1 | 1-8 |
| E,X | JP 2014-168054 A  (Canon Inc.),<br>11 September 2014 (11.09.2014),<br>claims 1, 5, 6; paragraphs [0027], [0129] to<br>[0136], [0150]<br>(Family: none) | 1,5-7 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003012373 A